# EUROPEAN PATENT APPLICATION

(11) **EP 4 668 000 A1**
(43) Date of publication of application: **24.12.2025**
(21) Application number: 24777925.9
(22) Date of filing: 22.03.2024
(51) Int. Cl.: G02B 27/00, B23K 26/38, B23K 26/046, B23K 26/064, B23K 26/70, B23K 26/02, B23K 26/04, B08B 5/02, H01S 3/04, H01S 5/024

(54) **LASER HEAD AND LASER PROCESSING DEVICE**

(30) Priority: 24.03.2023 CN 202320622060 U; 24.03.2023 CN 202320622033 U; 20.03.2024 CN 202420555872 U; 20.03.2024 CN 202420552623 U
(71) Applicant: Makeblock Co., Ltd., Shenzhen, Guangdong 518000 (CN)
(72) Inventor: SHEN, Changrong, Shenzhen, Guangdong 518000 (CN)
(74) Representative: Studio Torta S.p.A.
(86) International application number: PCT/CN2024/083351
(87) International publication number: WO 2024/199136

(57) **Abstract**

The present application provides a laser module and a laser processing device. The laser module includes: a housing, provided thereon with a laser exiting part capable of allowing a laser to emit from an interior of the housing; a laser emitting apparatus, accommodated in the housing and configured to emit a laser; and a focusing apparatus, accommodated in the housing and located between the laser exiting part and the laser emitting apparatus, wherein the focusing apparatus is configured to adjust a focal position of the laser emitting apparatus and enable laser emitted by the laser emitting apparatus to emit from the laser exiting part. According to the laser module provided by the present application, focusing can be realized under the condition that the height position of the laser module is not changed, the problems of unstable fixation of the laser module, easy loosening of the laser module and the like are avoided, and a user does not need to manually adjust a focusing process, thereby realizing automatic focusing, and improving the accuracy of focus adjustment.

## Description

This application claims priorities to Chinese Patent Application No. 202320622060.1 filed on March 24, 2023 and entitled "Housing Assembly and Laser Device", Chinese Patent Application No. 202320622033.4 filed on March 24, 2023 and entitled "Laser module", Chinese Patent Application No. 202420552623.9 filed on March 20, 2024 and entitled "Laser module and Laser Processing Device", and Chinese Patent Application No. 202420555872.3 filed on March 20, 2024 and entitled "Laser module and Laser Processing Device". The entire disclosures of the above-identified applications are hereby incorporated herein by reference.

### TECHNICAL FIELD

The present application relates to the field of laser processing, and more particularly to a laser module and a laser processing device.

### BACKGROUND

A laser module is a non-contact processing device using a laser as a medium. In laser processing operations such as laser engraving and laser cutting, a laser emitted from the laser module, while maintaining a certain distance from a workpiece, is applied to the surface of the workpiece for engraving or cutting, thereby achieving the purpose of processing.

A laser module is disposed in an existing laser processing device. The laser emitted from the laser module is focused through an optical lens. Since the energy is strongest at the focal point of the laser, the focal point of the laser is generally made to act on the surface of the workpiece during processing, resulting in a better processing effect on the workpiece. To facilitate the adjustment of the focal point, the laser processing device is provided with a locking structure for the height of the laser module. When the focal position needs to be adjusted, the user loosens the locking structure, manually adjusts the height of the laser module to adjust the focal position, and tightens the locking structure after adjusting the height of the laser module so as to fix the relative position between the laser module and the workpiece. However, since the laser module needs to move when the laser processing device is performing a workpiece processing task, the locking structure may loosen under such circumstances, leading to problems such as unstable fixation of the laser module.

### TECHNICAL SOLUTION

One objective of the present application is to provide a laser module. The focal position of a laser emitting apparatus can be adjusted by means of a focusing apparatus without adjusting the height position of a laser module, thereby meeting the focusing requirement and avoiding problems such as unstable fixation and easy loosening of the laser module caused by the movement of the laser module.

To solve the above technical problems, the present application adopts the following technical solutions:
According to the technical solution in one aspect of the present application, a laser module is provided, comprising: a housing, provided thereon with a laser exiting part capable of allowing laser to be emitted from an interior of the housing; a laser emitting apparatus, accommodated in the housing and configured to emit a laser; and a focusing apparatus, accommodated in the housing and located between the laser exiting part and the laser emitting apparatus, where the focusing apparatus is configured to adjust a focal position of the laser emitting apparatus and enabling the laser emitted by the laser emitting apparatus to be emitted from the laser exiting part.

Optionally, the focusing apparatus comprises a driving apparatus and a focusing lens that are connected, where the driving apparatus and the focusing lens are both accommodated in the housing, the focusing lens is configured to focus the laser emitted by the laser emitting apparatus, and the driving apparatus is configured to drive the focusing lens to move so as to adjust the focal position of the laser emitting apparatus.

Optionally, the focusing lens comprises a single-focal-length lens, where a moving distance of the single-focal-length lens is equal to a moving distance of a focal point of the laser emitting apparatus; or, the focusing lens comprises a multi-focal-length lens, where a ratio of a moving distance of the multi-focal-length lens to the moving distance of the focal point of the laser emitting apparatus is less than 1.

Optionally, the laser exiting part comprises a laser exiting window lens, the focusing lens is arranged in parallel with the laser exiting window lens, and a moving direction of the focusing lens is arranged at an angle to a laser emitting direction of the laser emitting apparatus; and the laser module further comprises a reflecting mirror, the reflecting mirror is accommodated in the housing, and the reflecting mirror is arranged corresponding to the laser emitting apparatus and the focusing lens respectively, and is configured to reflect the laser from the laser emitting apparatus to the focusing lens.

Optionally, the housing comprises: a first housing, provided with the laser exiting part, where the reflecting mirror and the focusing lens are both accommodated in the first housing, and along the moving direction of the focusing lens, the focusing lens is located between the reflecting mirror and the laser exiting part; and a second housing, an interior of which is in communication with an interior of the first housing, where the laser emitting apparatus is accommodated in the second housing, the laser emitting apparatus has an emitting end, and the emitting end is disposed opposite to the reflecting mirror and extends into the first housing to allow laser emitted by the laser emitting apparatus to reach the reflecting mirror.

Optionally, a first chamber and a second chamber are formed in the first housing; the first chamber and the second chamber are arranged adjacent to each other; the reflecting mirror and the focusing lens are both accommodated in the first chamber; the laser exiting part corresponds to the first chamber; one end of the second chamber is provided with first through-openings; the first through-openings are in communication with the interior of the second housing; and the other end of the second chamber is provided with second through-openings disposed opposite to the first through-openings.

Optionally, the laser module further comprises a fan; the second housing comprises a heat dissipation base and a heat dissipation cover; the heat dissipation base and the heat dissipation cover together define a first accommodating space; the laser emitting apparatus is accommodated in the first accommodating space; the fan is disposed at the end of the heat dissipation base and/or the heat dissipation cover away from the first housing; and the fan is configured to generate airflow to reduce the heat of the heat dissipation base and/or the heat dissipation cover.

Optionally, the driving apparatus comprises: a bracket which is connected to the housing, where both ends of the bracket are respectively provided with end plates arranged at an angle to the bracket, and the two end plates are arranged correspondingly and spaced apart; a lead screw nut which is provided with a lens holder for fixing the focusing lens; a lead screw which extends between the two end plates and is threadedly connected to the lead screw nut, and the lead screw is rotated to drive the lead screw nut to move axially along the lead screw; and a motor which is disposed on one of the end plates, where the lead screw passes through the end plate and is in transmission connection with the motor, and the motor is configured to drive the lead screw to rotate.

Optionally, the driving apparatus further comprises: guide rods, where both ends of each of the guide rods are respectively connected to the two end plates; two guide rods are provided, and the lead screw is located between the two guide rods in a direction perpendicular to a moving direction of the lead screw nut; and a middle portion of the lead screw nut is sleeved on the lead screw, and both side ends of the lead screw nut are each provided with an open slot, and the two guide rods are respectively inserted into the open slots at both side ends of the lead screw nut.

Optionally, the laser module further comprises: a ranging sensor disposed on the housing and configured to detect thickness information of an object to be processed, so that the focusing apparatus adjusts the focal position of the laser emitting apparatus based on the thickness information.

Optionally, the ranging sensor comprises an ultrasonic sensor; the ranging sensor and the laser exiting part are located on the same side of the housing and are spaced apart.

Optionally, the housing is provided with an air guide channel, and a surface of the housing is provided with an air outlet in communication with the air guide channel; and the laser module further comprises an air nozzle, the air nozzle is connected to the housing and covers the air outlet and the laser exiting part, a first channel facing the laser exiting part is formed inside the air nozzle, and a second channel is further defined inside the air nozzle and is in communication with the air outlet and the first channel.

According to the technical solution in one aspect of the present application, a laser processing device is provided, which comprises a rail structure and the laser module according to any one of the technical solutions described above, where the laser module is connected to the rail structure, and the rail structure is configured to drive the laser module to move in a first direction and a second direction that are perpendicular to each other; and the focusing apparatus of the laser module comprises a driving apparatus and a focusing lens that are connected; the driving apparatus drives the focusing lens to move in a third direction, and the third direction is perpendicular to the first direction and the second direction.

From the above technical solutions, it can be seen that the present application has at least the following advantages and positive effects:
The present application provides a laser module, where both the laser emitting apparatus and the focusing apparatus are accommodated in the housing of the laser module. Thus, the focal position of the laser emitting apparatus can be adjusted by means of the focusing apparatus without adjusting the height position of the laser module, thereby meeting the focusing requirements and avoiding problems such as unstable fixation and easy loosening of the laser module caused by the movement of the laser module. Furthermore, the focusing process does not require manual adjustment by the user, achieving automatic focusing and improving the accuracy of focal adjustment.

### BRIEF DESCRIPTION OF DRAWINGS

FIG. 1 is a front view illustrating the structure of a laser module according to one embodiment of the present application.
FIG. 2 is a schematic structural diagram of the A-A cross-section shown in FIG. 1.
FIG. 3 is a right side view illustrating the structure of a laser module according to one embodiment of the present application.
FIG. 4 is a schematic structural diagram of the B-B cross-section shown in FIG. 3.
FIG. 5 is a schematic structural diagram of the C-C cross-section shown in FIG. 3.
FIG. 6 is a schematic structural diagram of the D-D cross-section shown in FIG. 3.
FIG. 7 is a schematic diagram of a three-dimensional structure of a laser module according to one embodiment of the present application.
FIG. 8 is an exploded schematic structural diagram of a laser module according to one embodiment of the present application.
FIG. 9 is a schematic diagram of the combined structure of a driving apparatus and a focusing lens according to one embodiment of the present application.
FIG. 10 is a schematic diagram of the combined structure shown in FIG. 9 from another perspective.
FIG. 11 is a schematic diagram of a cross-section structure of a laser module (with the focusing apparatus removed) according to one embodiment of the present application.
FIG. 12 is a schematic diagram of a three-dimensional structure of a laser module according to one embodiment of the present application.
FIG. 13 is a perspective view illustrating the structure of an air nozzle according to one embodiment of the present application.
FIG. 14 is a schematic diagram of a three-dimensional structure of the air nozzle shown in FIG. 13 from another perspective.
FIG. 15 is a schematic diagram of a three-dimensional structure of a focusing part housing according to one embodiment of the present application.
FIG. 16 is a schematic diagram of a three-dimensional structure of the focusing part housing shown in FIG. 15 from another perspective.

Descriptions of the reference signs:
10, housing;
11, first housing;
1101, focusing part cover plate;
1102, focusing part housing;
112, laser exiting part;
1121, laser exit opening;
1122, laser exiting window lens;
1131, first chamber;
1132, second chamber;
1133, partition rib;
1141, first through-opening;
1142, second through-opening;
115, air guide channel;
1151, air outlet;
1152, air inlet;
117, peripheral side wall;
118, bottom plate;
119, laser entry opening;
12, second housing;
121, heat dissipation base;
1211, bottom wall;
12111, air intake;
1212, first side wall;
1213, second side wall;
1214, fin;
122, heat dissipation cover;
123, cover body;
1231, exhaust hole;
1232, receptacle;
1233, side opening;
ml, first accommodating space;
m2, second accommodating space;
124, side cover;
125, partition plate;
126, connecting bracket;
127, semiconductor cooling element;
n1, first gap;
n2, second gap;
16, clearance recess;
17, counterbore;
20, air nozzle;
X1, first channel;
X2, second channel;
P, convergence position;
21, connecting plate;
211, through hole;
212, annular tube;
213, recess;
2131, opening;
214, annular groove;
30, focusing lens;
40, reflecting mirror;
50, fan;
60, driving apparatus;
611, bracket;
612, end plate;
62, guide rod;
63, motor;
64, lead screw;
65, lens holder;
66, lead screw nut;
661, open slot;
70, ranging sensor;
80, laser emitting apparatus;
81, emitting end;
90, circuit board;
100, connection nozzle.

### DESCRIPTION OF THE EMBODIMENTS

Typical embodiments that embody the features and advantages of the present application will be described in detail in the following description. It should be understood that the present application may have various modifications in different embodiments, all of which do not depart from the scope of the present application. The descriptions and illustrations herein are essentially for illustrative purposes and are not intended to limit the present application.

In the description of the present application, it should be understood that orientation or positional relationships indicated by the terms such as "center," "longitudinal," "transverse," "length," "width," "thickness," "upper," "lower," "front," "rear," "left," "right," "vertical," "horizontal," "top," "bottom," "inner," "outer," "clockwise," "counterclockwise", are based on the orientation or positional relationships shown in the drawings. These are provided solely for the convenience of description and to simplify the explanation of the present application, and are not intended to indicate or imply that the apparatuses or elements referred to must have a specific orientation or be constructed and operated in a specific orientation, and therefore cannot be construed as limiting the present application. In addition, the terms "first" and "second" are used for descriptive purposes only and are not to be construed as indicating or implying relative importance or as implicitly indicating the number of technical features referred to. Thus, the features defined by "first" and "second" may explicitly or implicitly include one or more of the features. In the description of the present application, unless otherwise expressly and specifically limited, "a plurality" means two or more.

In the description of the present application, it should be noted that unless otherwise explicitly specified or limited, the terms "mounted," "connected," and "coupled" are to be interpreted broadly. For example, they may refer to a fixed connection, a detachable connection, or an integral connection. The connection may be mechanical or electrical. The connection may be direct or indirect through an intermediate medium, and may refer to communication within or interaction between two elements. The specific meanings of the above terms in the present application may be understood by those of ordinary skill in the art depending on specific circumstances.

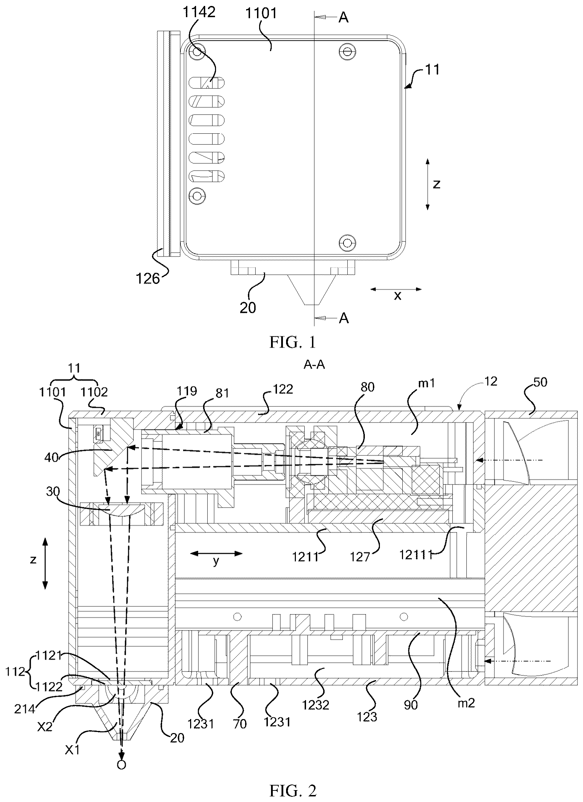

With reference to FIG. 1 and FIG. 2, some embodiments of the present application provide a laser module, which includes a housing 10, a laser emitting apparatus 80, and a focusing apparatus. The housing 10 is provided with a laser exiting part 112 capable of allowing a laser to be emitted from an interior of the housing 10; a laser emitting apparatus 80 accommodated in the housing 10 and configured to emit the laser; and a focusing apparatus accommodated in the housing 10, located between the laser exiting part 112 and the laser emitting apparatus 80 and configured to adjust a focal position of the laser emitting apparatus and enable the laser emitted by the laser emitting apparatus 80 to be emitted from the laser exiting part 112.

In the embodiments of the present application, the focusing apparatus and the laser emitting apparatus 80 are disposed in the housing 10 of the laser module. Thus, the focal position of the laser emitting apparatus 80 can be adjusted by means of the focusing apparatus without adjusting the height position of the laser module, thereby meeting the focusing requirements and avoiding the problems such as unstable fixation and easy loosening of the laser module caused by the movement of the laser module.

It can be understood that, in other embodiments, the laser emitting apparatus and/or the focusing apparatus are arranged outside the housing of the laser module. For example, the laser emitting apparatus and/or the focusing apparatus are suspended on the housing and are mounted on the outside of the housing of the laser module as temporary components. In comparison, a structure in which the laser emitting apparatus 80 and the focusing apparatus are both accommodated in the housing 10 of the laser module can achieve a more compact arrangement among product components and save product space, thereby facilitating the miniaturization and lightweight development of products. By integrating the laser emitting apparatus 80 and the focusing apparatus in the same housing 10, the stability of an optical path during laser processing can be more easily ensured, thereby providing higher processing precision. In addition, the laser emitting apparatus 80 and the focusing apparatus can be accommodated in the housing 10 to achieve a good dust protection effect, which greatly avoids situations where the laser emitting apparatus 80 and/or the focusing apparatus may have positional deviation relative to the housing 10 due to collision or movement of the laser module. Accordingly, problems such as uncontrollable processing accuracy caused by positional errors can be avoided, and adverse effects on connection position accuracy due to frequent disassembly and cleaning of the focusing apparatus can also be prevented, thereby better ensuring the processing quality of workpieces.

In some embodiments, the focusing apparatus may include a focusing lens 30, which is configured to focus the laser emitted by the laser emitting apparatus 80. The focusing lens 30 is accommodated in the housing 10 and is configured to be movable within the housing 10. That is, the focusing lens 30 is movably arranged within the housing 10. For example, as shown in FIG. 2, the focusing lens 30 is moved within the housing 10 along a z-direction to adjust the focal position. In this way, by moving the focusing lens 30 to change the position of a laser focal point O, the laser can process workpieces of different thicknesses, thereby better meeting various processing requirements. By moving the focusing lens 30 to perform focusing, the laser module does not need to move in the z-direction during focal length adjustment, which simplifies the structure of the laser processing device by eliminating the need for arranging a structure that moves in the z-direction for the laser module. This facilitates implementation and reduces cost. Moreover, based on the design that the focusing lens 30 is accommodated in the housing 10, the dust protection effect provided by the housing 10 can improve the movement smoothness and vibration resistance of the focusing lens 30. Thus, the accuracy of focusing by moving the focusing lens 30 is more easily ensured.

Optionally, the focusing lens 30 includes a single-focal-length lens, and a moving distance of the single-focal-length lens is approximately equal to a moving distance of a focal point of the laser emitting apparatus 80. This allows for more precise adjustment of the focal position of the laser emitting apparatus 80.

Optionally, the focusing lens 30 includes a multi-focal-length lens, and a ratio of a moving distance of the multi-focal-length lens to a moving distance of the focal point of the laser emitting apparatus 80 is less than 1. This enables a greater adjustment range for the focal position of the laser emitting apparatus 80, thereby reducing the range of movement space required for the focusing lens 30 within the housing 10, and facilitating the miniaturization of the laser module.

In some embodiments, as shown in FIG. 2, the laser exiting part includes a laser exiting window lens 1122. The focusing lens 30 is disposed in parallel with the laser exiting window lens 1122. A moving direction (e.g., z-direction) of the focusing lens 30 is arranged at an angle to a laser emitting direction (e.g., y-direction) of the laser emitting apparatus 80. The laser module further includes a reflecting mirror 40, which is accommodated in the housing 10. The reflecting mirror 40 is arranged corresponding to the laser emitting apparatus 80 and the focusing lens 30, respectively, and is configured to reflect the laser emitted by the laser emitting apparatus 80 to the focusing lens 30. By using the reflecting mirror 40 to reflect the laser between the focusing lens 30 and the laser emitting apparatus 80, the moving direction of the focusing lens 30 can be configured at an angle to the laser emitting direction of the laser emitting apparatus 80. This configuration features a simple structure and allows the movement space of the focusing lens 30 to occupy as little space as possible in the housing 10 along the laser emitting direction, thereby meeting the movement requirement of the focusing lens 30 while reducing the overall volume of the laser module, and facilitating miniaturization and lightweight development of the product.

In some embodiments, as shown in FIG. 2, the housing 10 includes a first housing 11 and a second housing 12. The first housing 11 is provided with the laser exiting part 112. The reflecting mirror 40 and the focusing lens 30 are both accommodated in the first housing 11. The moving direction of the focusing lens 30 is perpendicular to a preset direction y. Along the moving direction of the focusing lens 30, the focusing lens 30 is located between the reflecting mirror 40 and the laser exiting part 112. The second housing 12 is connected to one end of the first housing 11 along the preset direction y. An interior of the second housing 12 is in communication with an interior of the first housing 11. The laser emitting apparatus 80 is accommodated in the second housing 12. The laser emitting apparatus 80 has an emitting end 81, which is arranged opposite to the reflecting mirror 40 and extends into the first housing 11 along the preset direction y, so as to allow the laser emitted by the laser emitting apparatus 80 to reach the reflecting mirror 40. By configuring the moving direction of the focusing lens 30 (i.e., the z-direction as shown in FIG. 2) to be perpendicular to the direction in which the emitting end 81 extends into the first housing 11, thereby meeting the movement requirements of the focusing lens 30 while reducing a height of the laser module in a z-axis direction. Since the focusing lens 30 and the laser emitting apparatus 80 are separately accommodated in the first housing 11 and the second housing 12, the different working environment requirements of the focusing lens 30 and the laser emitting apparatus 80 can be better balanced. For example, this configuration takes into account the dust protection requirement of the focusing lens 30 and the ventilation and heat dissipation requirement of the laser emitting apparatus 80, thereby reducing mutual interference between the working environments of the two. By connecting the first housing 11 and the second housing 12 and extending the emitting end 81 into the first housing 11, a physical connection is established between the laser emitting apparatus 80 and the first housing 11 for internally accommodating the focusing lens 30. This design not only meets the requirement of separately housing the focusing lens 30 and the laser emitting apparatus 80 in different housings to avoid interference of the working environment, but also better ensures the reliability of relative positional accuracy between the laser emitting apparatus 80, the first housing 11, and the focusing lens 30, thereby better guaranteeing the stability of the laser optical path.

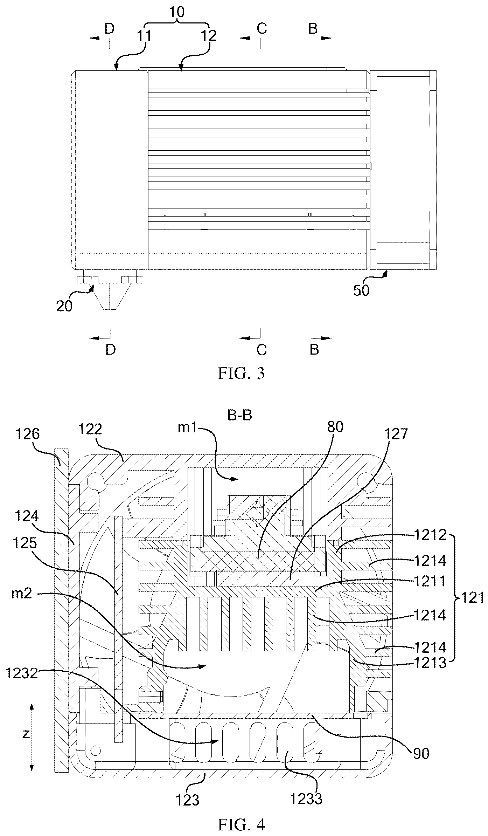

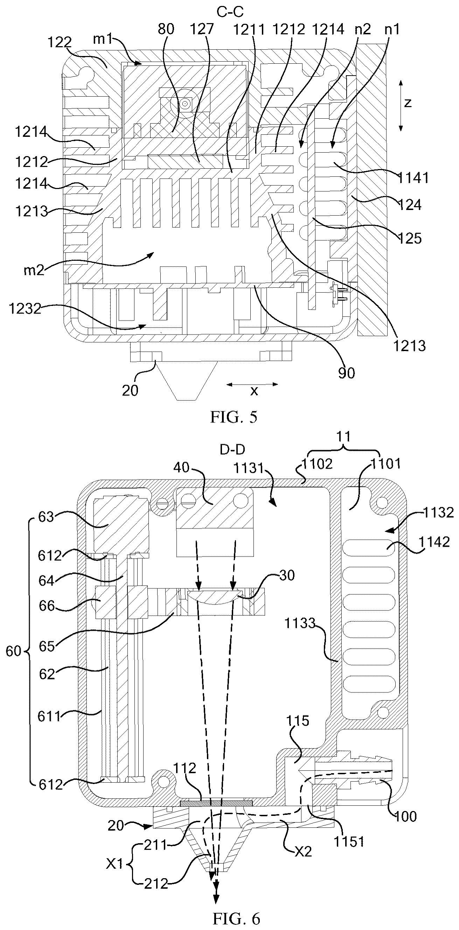

With reference to FIG. 3 and FIG. 6, it can be understood that a first chamber 1131 and a second chamber 1132 are formed within the first housing 11. The first chamber 1131 and the second chamber 1132 are arranged adjacent to each other. Both the reflecting mirror 40 and the focusing lens 30 are accommodated in the first chamber 1131. The laser exiting part 112 corresponds to the first chamber 1131. The second chamber 1132 is provided with first through-openings 1141 at the end close to the second housing 12 along the preset direction y, and the first through-openings 1141 are in communication with the interior of the second housing. The second chamber 1132 is provided with second through-openings 1142 at the end away from the second housing 12 along the preset direction y, and the first through-openings 1141 and the second through-openings 1142 are opposite each other along the preset direction y. By providing the corresponding first through-openings 1141 and second through-openings 1142 at opposite ends of the second housing 12, convection can be formed, allowing a heat dissipation airflow to flow through the first through-openings 1141, the second chamber 1132, and the second through-openings 1142, thereby carrying away the heat within the first chamber 1131 while preventing the airflow from bringing dust into the first chamber 1131, thus reducing the risk of contamination of the focusing lens.

The laser module further includes a fan 50, which is disposed at the end of the second housing 12 away from the first housing 11. The second housing 12 is in communication with both the fan 50 and the first through-openings 1141. In this way, the fan 50 drives the airflow through the second housing 12 to dissipate heat from the laser emitting apparatus 80. The airflow can then further enter the second chamber 1132 through the first through-openings 1141 and is discharged from the second through-openings 1142 after passing through the second chamber 1132. During the process of the airflow passing through the second chamber 1132, the airflow can carry away the heat from the first chamber 1131 adjacent to the second chamber 1132, thereby improving the ambient temperature inside the first chamber 1131, preventing overheating of instruments inside the first chamber 1131, and preventing the airflow from bringing dust into the first chamber 1131, thereby reducing the risk of contamination of the focusing lens.

Preferably, with reference to FIG. 3, FIG. 4, and FIG. 5, it can be understood that the second housing 12 is provided with a heat dissipation structure for dissipating heat from the laser emitting apparatus 80. The heat dissipation structure includes at least one of fins 1214 and a semiconductor cooling element 127. The second housing 12 is provided with fins 1214 and/or a semiconductor cooling element 127 to dissipate heat from the laser emitting apparatus 80. Combined with the airflow heat dissipation of the fan 50, the heat dissipation effect of the laser emitting apparatus 80 can be further improved, and a lower operating temperature of the laser emitting apparatus 80 can be achieved, thereby better ensuring the reliability of the laser emitting apparatus 80.

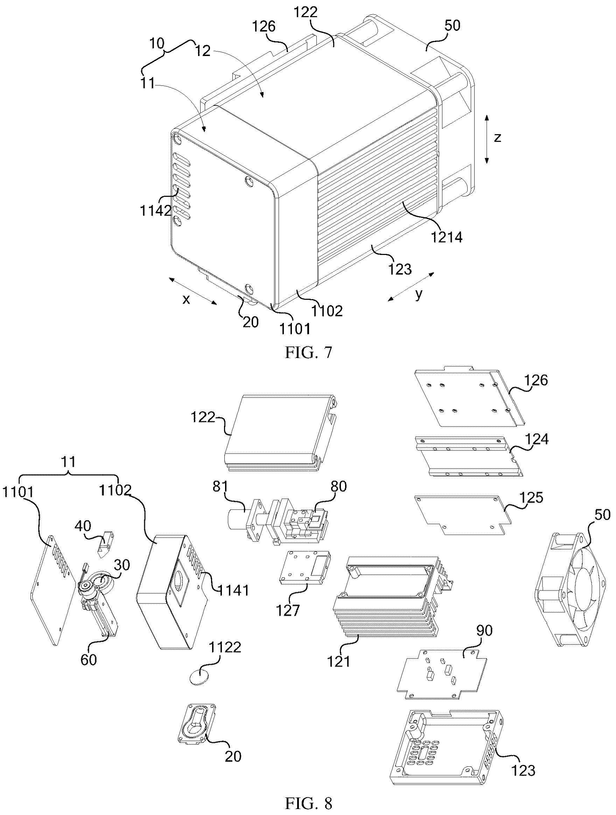

In some embodiments, with reference to FIG. 7 and FIG. 8, it can be understood that the second housing 12 includes a heat dissipation base 121 and a heat dissipation cover 122. The heat dissipation base 121 and the heat dissipation cover 122 together define a first accommodating space m1. The laser emitting apparatus 80 is accommodated in the first accommodating space m1. The first accommodating space m1 is in communication with the first chamber 1131 of the first housing 11, so that the emitting end 81 of the laser emitting apparatus 80 can extend into the first chamber 1131.

As shown in FIG. 2, the fan 50 is disposed at the end of the heat dissipation base 121 and/or the heat dissipation cover 122 away from the first housing 11, and the fan 50 is configured to generate the airflow to reduce the heat of the heat dissipation base 121 and/or the heat dissipation cover 122. Thus, more efficient active heat dissipation of the laser emitting apparatus 80 is achieved.

As shown in FIG. 6, the focusing apparatus further includes a driving apparatus 60, which is accommodated in the housing 10. The driving apparatus 60 is connected to the focusing lens 30 and is configured to drive the movement of the focusing lens 30 to adjust the focal position of the laser emitting apparatus 80. In this way, automatic focusing can be achieved, thereby achieving more precise adjustment of the position of the laser focal point O. Furthermore, the design of accommodating the driving apparatus 60 in the housing 10 takes into account the dust protection of the driving apparatus 60, so that the driving apparatus 60 can drive the movement of the focusing lens 30 more reliably and precisely. Moreover, the focusing process does not require manual adjustment by the user, realizing automated focusing and improving the accuracy of focal point adjustment.

Optionally, as shown in FIG. 2, the laser module further includes a ranging sensor 70, which is disposed on the housing 10 and is configured to detect the thickness information of the object to be processed, so that the focusing apparatus can adjust the focal position of the laser emitting apparatus 80 based on the thickness information. In this way, after the workpiece to be processed is placed at the bottom of the laser module, the ranging sensor 70 reads the thickness information of the workpiece. A laser module system determines the position of the focusing lens 30 based on the thickness information and controls the driving apparatus 60 to operate according to the determined position of the focusing lens 30, so that the driving apparatus 60 drives the focusing lens 30 to move to the determined position of the focusing lens 30.

It can be understood that in some embodiments, laser focus adjustment is performed manually, with a focal length adjusted via a focal length gauge or a focusing limit structure. This manual focusing method relies heavily on the operator's experience, resulting in low precision, high susceptibility to errors, and long time consumption. For first-time users of laser products, an extended learning period is required. In contrast, in this embodiment, the ranging sensor 70 detects the thickness information of the workpiece. Based on this thickness information, the driving apparatus 60 drives the focusing lens 30 to move to a position corresponding to the thickness information, thereby achieving automatic focusing. The entire process requires no manual operation, which improves focusing accuracy and shortens focusing time.

Optionally, the ranging sensor 70 includes an ultrasonic sensor. The ultrasonic sensor provides higher accuracy in detecting the thickness information of the workpiece. Of course, the design is not limited thereto. In other embodiments, the ranging sensor 70 may also be a laser ranging sensor 70 or the like.

Optionally, as shown in FIG. 2, the ranging sensor 70 and the laser exiting part 112 are located on the same side of the housing 10, and the ranging sensor 70 is spaced apart from the laser exiting part 112. In this way, when the workpiece is aligned with the laser module, the workpiece is located on the same side of the ranging sensor 70 and the laser exiting part 112. Ranging and laser processing can be achieved in one alignment, thereby better ensuring processing accuracy.

Optionally, as shown in FIG. 6, FIG. 9, and FIG. 10, the driving apparatus 60 may include a bracket 611, two end plates 612 at both ends of the bracket 611, a lead screw nut 66, a lead screw 64, and a motor 63. The bracket 611 is connected to the housing 10. The two end plates 612 at both ends of the bracket 611 are arranged at an angle relative to the bracket 611, and the two end plates 612 are arranged correspondingly and spaced apart. The lead screw nut 66 is provided with a lens holder 65 for fixing the focusing lens 30. The lead screw 64 extends between the two end plates 612 and is threadedly connected to the lead screw nut 66. The lead screw 64 is rotated to drive the lead screw nut 66 to move axially along the lead screw 64. The motor 63 is disposed on one of the end plates 612, the lead screw 64 passes through the end plate 612 and is in transmission connection with the motor 63, and the motor 63 is configured to drive the lead screw 64 to rotate. The lead screw 64 is driven to rotate by the motor 63, causing the lead screw nut 66 to move axially along the lead screw 64. Consequently, the lens holder 65 mounted on the lead screw nut 66 and the focusing lens 30 are displaced accordingly, achieving position adjustment of the focusing lens 30 and thereby adjusting the focal position of the laser emitting apparatus 80. This driving apparatus has the advantages of high adjustment precision and fast response speed, enabling more precise adjustment of the focal position.

Optionally, as shown in FIG. 6, FIG. 9, and FIG. 10, the driving apparatus may further include guide rods 62. Both ends of each of the guide rods 62 are connected to the two end plates 612, respectively. Two guide rods 62 are arranged along a direction perpendicular to the moving direction of the lead screw nut 66, and the lead screw 64 is located between the two guide rods 62. The displacement of the lead screw nut 66 is guided by the two guide rods 62, preventing radial deviation of the lead screw nut 66, thereby ensuring higher focusing precision of the laser module. The driving apparatus 60 is assembled with the housing 10 by connecting the bracket 611 to the housing 10. The bracket 611 serves as a carrier to support the guide rods 62, the lead screw nut 66, the lead screw 64, and the motor 63, thereby achieving modularization and integration of the driving apparatus 60. This is more conducive to the assembly efficiency of a product assembly line.

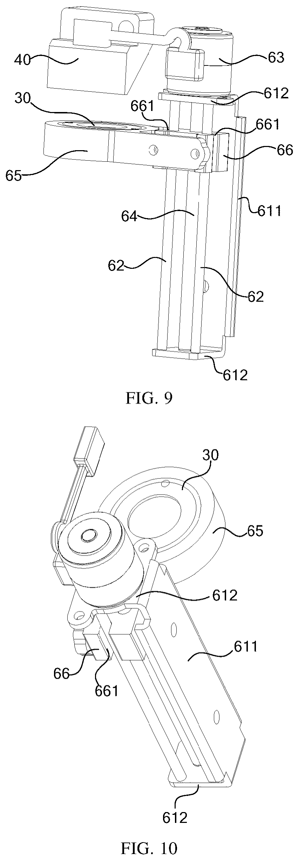

Optionally, two guide rods 62 are provided between the two end plates 612 and spaced apart from each other, and the lead screw 64 is disposed in the space between the two guide rods 62. The middle portion of the lead screw nut 66 is sleeved on the lead screw 64. As shown in FIG. 10, both side ends of the lead screw nut 66 are each provided with an open slot 661, and the two guide rods 62 are respectively inserted into the open slots 661 at both side ends of the lead screw nut 66. In this way, after the lead screw nut 66 is assembled with the lead screw 64 and the two guide rods 62, the guide rods 62 limit the lead screw nut 66 between the two guide rods 62 from both sides. This prevents the guide rods 62 from detaching from openings of the open slots 661, and the two guide rods 62 can more reliably restrict the lead screw nut 66 from rotating with the lead screw 64, thereby enabling the lead screw 64 to drive the lead screw nut 66 with higher precision.

In summary, in this embodiment, the motor 63 converts rotational motion into linear motion of the lead screw nut 66 via the lead screw 64. The focusing lens is disposed on the lens holder 65 connected to the lead screw nut 66. When receiving a motion command, the motor 63 rotates to displace the laser focusing lens to a corresponding position. The laser emitting apparatus 80 then emits a laser (the laser optical path can be roughly understood by referring to a dotted line direction shown in FIG. 2). When a laser spot hits the reflecting mirror 40, the reflecting mirror 40 changes the optical path by 90 degrees, converting the parallel laser into a vertically downward laser. The laser passes through the focusing lens that is driven into position by the motor 63 (i.e., a focal length has been adjusted), then passes through the laser exiting part 112, and reaches the surface of the workpiece. At this point, the focal length is precisely at a consumable surface, and laser processing begins. Simultaneously, the system automatically adjusts the laser focal length based on the currently measured distance to ensure that the processed workpiece is within a processing focal range.

Optionally, the motor 63 is a stepper motor.

In a specific embodiment, the structure of the laser module will be illustrated in further detail by way of example with reference to a spatial coordinate system x-y-z:
With reference to FIG. 7 and FIG. 8, it can be understood that the laser module includes a housing 10, a laser emitting apparatus 80, a focusing lens 30, a fan 50, a driving apparatus 60, a ranging sensor 70, a circuit board 90, and an air nozzle 20 disposed on the housing 10.

The laser emitting apparatus 80, the focusing lens 30, the driving apparatus 60, the ranging sensor 70, and the circuit board 90 are all accommodated in the housing 10 to form a main part of the laser module, and the main part is generally an integrated structure with the housing 10 serving as the external appearance.

More specifically, the housing 10 includes a first housing 11 and a second housing 12. The first housing 11 is disposed at one end of the second housing 12 in a y-direction, and the fan 50 is disposed at the other end of the second housing 12 in the y-direction. More specifically, the second housing 12, the first housing 11, and the fan 50 can be fastened together by screws, respectively.

The cross-sectional shapes of the first housing 11, the second housing 12, and the fan 50 in a y-z plane are generally the same, and each is square or rectangular. In this way, the first housing 11, the second housing 12, and the fan 50 are arranged in sequence along the y-direction, thereby being assembled into a substantially rectangular main part.

The first housing 11 specifically includes a focusing part cover plate 1101 and a focusing part housing 1102. The focusing part cover plate 1101 is disposed on one side of the focusing part housing 1102 opposite to the second housing 12. A partition rib 1133 is provided inside the focusing part housing 1102. The focusing part cover plate 1101 and the focusing part housing 1102 together define a first chamber 1131 and a second chamber 1132, which are two adjacent chambers separated by the partition rib 1133.

As shown in FIG. 6, an air guide channel 115 is integrally formed on the focusing part housing 1102 of the first housing 11, and an air outlet 1151 in communication with the air guide channel 115 is provided on a surface of the first housing 11. The first housing 11 is also provided with a laser exit opening 1121 of the first chamber 1131 and a laser exiting window lens 1122 covering the laser exit opening 1121. The laser exiting part 112 of the housing 10 includes the laser exit opening 1121 and the laser exiting window lens 1122.

The air outlet 1151 and the laser exiting part 112 are both located at one end of the first housing 11 in the z-direction. At the end of the first housing 11 in the z-direction, an air nozzle 20 is also provided. The air nozzle 20 is connected to the first housing 11 and integrally covers the air outlet 1151 and the laser exiting part 112. A first channel X1 is formed inside the air nozzle 20, directly facing the laser exiting part 112, so that the laser emitted from the laser exiting part 112 can further pass through the first channel X1 and reach the surface of the workpiece for processing. Furthermore, a second channel X2 is also defined within the air nozzle 20. The second channel X2 is in communication with the air outlet 1151 and the first channel X1. In this way, the air nozzle 20 is in communication with the air guide channel 115 on the first housing 11 via the second channel X2. An air pump can deliver gas into the air nozzle 20 via the air guide channel 115, allowing the air nozzle 20 to blow air along the first channel X1 to purge dust or dirt from the surface of the workpiece. Moreover, gas is guided to the air nozzle 20 through the air guide channel 115 formed within the first housing 11, and no external pipeline is arranged on the air nozzle 20. In this way, the problem of pipeline collision or burns at the position of the air nozzle 20 is less likely to occur, which better ensures the reliability of a gas path of the laser module.

Preferably, the second channel X2 is in communication with one end of the first channel X1 close to the laser exiting part 112. In this way, as the second channel X2 delivers gas to the first channel X1, the gas is blown across a surface of the laser exiting window lens 1122 of the laser exiting part 112, thereby reducing the probability of contamination of the laser exiting window lens 1122 and preventing frequently cleaning of the laser exiting window lens 1122 by users.

As shown in FIG. 6, the driving apparatus 60, the focusing lens 30, and the reflecting mirror 40 are all accommodated in the first chamber 1131. The second chamber 1132 of the focusing part housing 1102 is provided with first through-openings 1141 at the end close to the second housing 12, and the focusing part cover plate 1101 is provided with second through-openings 1142 at the position corresponding to the second chamber 1132. This allows the fan 50 to drive the gas to flow through the second chamber 1132 for heat dissipation, reducing the temperature of the first housing 11 and, to some extent, improving the operating temperature environment for the driving apparatus 60, the focusing lens 30, and the reflecting mirror 40.

As shown in FIG. 2, the emitting end 81 of the laser emitting apparatus 80 extends through the focusing part housing 1102 into the first chamber 1131 along the y-direction (i.e., the preset direction), and the reflecting mirror 40 is disposed opposite to the emitting end 81 in the y-direction. Extending directions of the lead screw 64 and the guide rods 62 of the driving apparatus 60 are substantially parallel to the z-direction, and the extending directions are substantially perpendicular to an insertion direction of the emitting end 81. In this way, the space inside the first housing 11 in the z-direction is more fully utilized to allow the focusing lens to move, thereby reducing the overall size of the laser module in the y-direction to a certain extent and achieving higher miniaturization of the product.

As shown in FIG. 5, FIG. 7, and FIG. 8, the second housing 12 specifically includes a heat dissipation base 121, a heat dissipation cover 122, and a cover body 123. The heat dissipation cover 122 and the cover body 123 are connected to the heat dissipation base 121 in a covering manner from opposite sides in the z-direction. The laser emitting apparatus 80 is disposed on the heat dissipation base 121, where the heat dissipation base 121 is provided with a heat dissipation structure for heat dissipation and cooling of the laser emitting apparatus 80. Specifically, the heat dissipation structure includes fins 1214 and/or a semiconductor cooling element 127.

By way of detailed example, the heat dissipation base 121 has a bottom wall 1211, two opposing first side walls 1212 extending from the bottom wall 1211 toward the heat dissipation cover 122, and two opposing second side walls 1213 extending from the bottom wall 1211 toward the cover body 123. The fins 1214 are disposed on the sides of the two first side walls 1212 facing away from each other, and the fins 1214 are also disposed on the sides of the two second side walls 1213 facing away from each other. The bottom wall 1211 and the two first side walls 1212 define an accommodating groove, and the heat dissipation cover 122 is located on the side of the bottom wall 1211 close to the accommodating groove. The heat dissipation cover 122 and the accommodating groove together define a first accommodating space m1. The laser emitting apparatus 80 is accommodated in the accommodating groove. More specifically, the laser emitting apparatus 80 is located on the bottom wall 1211. Preferably, the semiconductor cooling element 127 is disposed between the bottom wall 1211 and the laser emitting apparatus 80. A cold end of the semiconductor cooling element 127 is used for heat absorption and in contact with the laser emitting apparatus 80, and a hot end of the semiconductor cooling element 127 is used for heat dissipation and in contact with the bottom wall 1211. A lower heat dissipation temperature of the laser emitting apparatus 80 can be achieved by using the semiconductor cooling element 127. The fins 1214 are disposed on the side of the bottom wall 1211 opposite to the accommodating groove. The bottom wall 1211 and the two second side walls 1213 define a second accommodating space m2, and the fins 1214 of the bottom wall 1211 extend into the second accommodating space m2. As shown in FIG. 2, the bottom wall 1211 is provided with an air intake 12111, and the accommodating groove is in communication with the fan 50 via the air intake 12111.

As shown in FIG. 4 and FIG. 5, the circuit board 90 is arranged between the heat dissipation base 121 and the cover body 123. An opening is formed at the end of the second accommodating space m2 away from the bottom wall 1211. The cover body 123 defines a receptacle 1232. One side of the circuit board 90 faces the opening of the second accommodating space m2, and the other side of the circuit board 90 faces the receptacle 1232. The second accommodating space m2 is a structure penetrating in the y-direction, and one end of the second accommodating space m2 in the y-direction close to the fan 50 corresponds to and is in communication with the fan 50. The receptacle 1232 is provided with a side opening 1233 at the end close to the fan 50 in the y-direction, and the receptacle 1232 is in communication with the fan 50 via the side opening 1233.

As shown in FIG. 2, the ranging sensor 70 is arranged on the side of the circuit board 90 facing away from the heat dissipation base 121, and the end of the ranging sensor 70 away from the circuit board 90 passes through the cover body 123 to be exposed on a surface of the laser module.

As shown in FIG. 4 and FIG. 5, the second housing 12 further includes a side cover 124, a partition plate 125, and a connecting bracket 126. The side cover 124 covers one side of the heat dissipation base 121 in the x-direction. The connecting bracket 126 is arranged on the side of the side cover 124 facing away from the heat dissipation base 121. The connecting bracket 126 is configured to connect and assemble the laser module. For example, the connecting bracket 126 is connected to a tail end of a robot arm so that the laser module is mounted on the robot arm and moves under the driving of the robot arm to process the workpiece.

The side cover 124 faces the first side wall 1212 and the second side wall 1213 on one side of the heat dissipation base 121. A partition plate 125 is arranged between the side cover 124 and the heat dissipation base 121, a first gap n1 is formed between the partition plate 125 and the side cover 124, and a second gap n2 is formed between the partition plate 125 and the first side wall 1212 and the second side wall 1213 on one side of the heat dissipation base 121. The fins 1214 of the first side wall 1212 and the second side wall 1213 are accommodated in the second gap n2. A portion of an area of the first through-openings 1141 of the first housing 11 faces the first gap n1 in the y-direction, and another portion of the area of the first through-openings 1141 of the first housing 11 faces the second gap n2 in the y-direction. Thus, under the driving of the fan 50, a portion of the airflow enters the second chamber 1132 along the first gap n1, and another portion of the airflow enters the second chamber 1132 along the second gap n2, so that the temperature of the airflow entering the second chamber 1132 is distributed to prevent the temperature of the airflow inside the second chamber 1132 from becoming excessively high. At the same time, the built-in fins 1214 on the first side wall 1212 and the second side wall 1213, which are covered by the side cover 124 can be fully ventilated and cooled, thereby better ensuring the heat dissipation effect for the laser emitting apparatus 80, while also meeting the exhaust requirements at the second gap n2 and better balancing the internal and external air pressure of the laser module.

Preferably, a total area of the first through-openings 1141 facing the first gap n1 is greater than a total area of the first through-openings 1141 facing the second gap n2, thereby further improving the heat dissipation effect of the first chamber 1131 and the second chamber 1132.

At least a portion of the fins 1214 of the heat dissipation base 121 are disposed externally. The fins 1214 disposed externally can promptly exchange heat with the external space by convection, further enhancing the heat dissipation effect for the laser emitting apparatus 80.

For example, the side of the heat dissipation base 121 away from the side cover 124 in the x-direction exposes the first side wall 1212, the second side wall 1213, and the fins 1214 of the first side wall 1212 and the second side wall 1213 on the other side of the heat dissipation base 121. That is, the fins 1214 of the first side wall 1212 and the second side wall 1213 on the side of the heat dissipation base 121 away from the side cover 124 in the x-direction are disposed externally. In this way, the externally disposed fins 1214 can promptly exchange heat with the external space by convection, further enhancing the heat dissipation effect for the laser emitting apparatus 80.

Preferably, a laser direction of the laser emitting apparatus 80 (which can be understood with reference to a dash-dotted line shown in FIG. 2) and an air outlet direction of the fan 50 (which can be understood with reference to a double dash-dot line shown in FIG. 2) are in the same direction, for example, both facing the direction of the first housing 11. This better combines the heat distribution at different positions along the y-direction of the second housing 12, thereby optimizing the heat dissipation efficiency of the fan 50.

Preferably, the fins 1214 of the heat dissipation base 121 all extend in the y-direction, with the fan 50 located at one end of the fins 1214 in the y-direction. The air outlet direction of the fan 50 (which can be understood with reference to the double dash-dot line shown in FIG. 2) is substantially parallel to the y-direction. In this way, the airflow driven by the fan 50 can evenly pass through gaps between the fins 1214, thereby achieving more efficient ventilation and heat dissipation.

Preferably, the bracket 611 of the driving apparatus 60 is located at the end of the external fins 1214 away from the fan 50, and the bracket 611 and the external fins 1214 are separated by a wall of the focusing part housing 1102. In this way, the heat generated by the driving apparatus 60 can also be promptly dissipated through the external fins 1214, achieving more efficient heat dissipation for the driving apparatus 60.

In the specific embodiment, the laser emitting apparatus 80, the focusing lens 30, the driving apparatus 60, the ranging sensor 70, and the circuit board 90 are all accommodated in the housing 10, providing good protection for the built-in components and better ensuring the processing accuracy of the laser module. Furthermore, through the structural design of the housing 10 and the positional arrangement of the laser emitting apparatus 80, the focusing lens 30, the fan 50, the driving apparatus 60, the ranging sensor 70, the circuit board 90, and the air nozzle 20 inside and outside the housing 10, a compact arrangement and sufficient heat dissipation of components of the laser module are achieved. While achieving miniaturization, the heat dissipation requirements of the components of the laser module are also met, improving the reliability of the product.

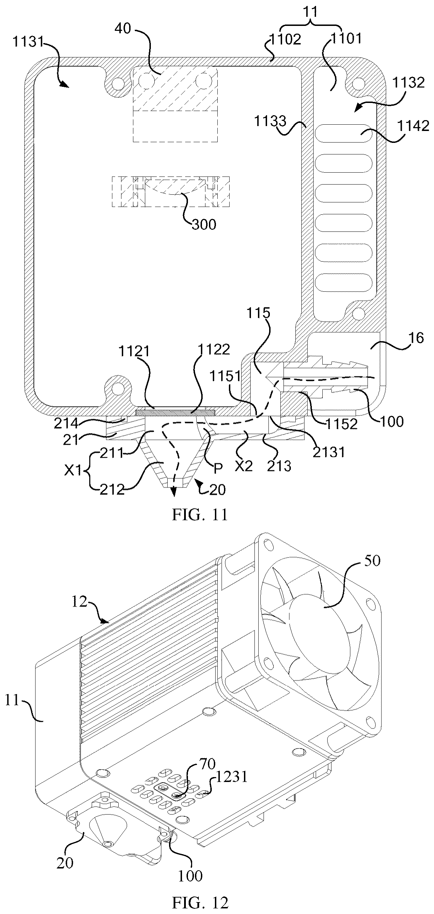

With reference to FIGs. 1 to 16, some embodiments of the present application provide a laser module. The laser module is specifically used for emitting a laser to process workpieces (such as engraving, cutting, drilling, etc.), cleaning, and other applications. The laser module includes a first housing 11, a laser emitting apparatus 80, a focusing apparatus, and so on. As shown in FIG. 11, a first chamber 1131 is provided inside the first housing 11. A laser entry opening 119, a laser exit opening 1121, and a laser exiting window lens 1122 covering the laser exit opening 1121 are provided on the first housing 11 corresponding to the first chamber 1131. The laser emitting apparatus 80 is provided with an emitting end 81 for emitting a laser, and the emitting end 81 is inserted into the laser entry opening 119 to seal the first chamber 1131. By using the emitting end 81 and the laser exiting window lens 1122 to seal the laser entry opening 119 and the laser exit opening 1121, so that the first chamber 1131 is maintained in a better sealed state, thereby better maintaining a dust-free effect.

The focusing apparatus is accommodated in the first chamber 1131 and is arranged between the emitting end 81 and the laser exit opening 1121. The focusing apparatus is configured to adjust the focal position of the laser emitting apparatus 80 and to allow the laser emitted by the laser emitting apparatus 80 to be emitted from the laser exit opening 1121. Since the focusing apparatus is accommodated in the first chamber 1131, the probability or risk of contamination of the focusing apparatus is greatly reduced, the dust protection effect of the focusing apparatus is improved, and the protection of the focusing apparatus is facilitated. Users do not need to frequently clean the focusing apparatus, so that the focusing apparatus is more convenient to use.

Optionally, the focusing apparatus includes a focusing lens 30. The focusing lens 30 is located inside the first chamber 1131 and is arranged between the emitting end 81 and the laser exit opening 1121, so that the laser emitted from the emitting end 81 of the laser emitting apparatus 80 passes through the focusing lens 30 and then further passes through the laser exiting window lens 1122 for emission. The focusing lens 30 is configured to focus the laser emitted from the emitting end 81 of the laser emitting apparatus 80, thereby adjusting the focal position of the laser emitting apparatus 80. The structure in which the focusing lens 30 is accommodated within the first chamber 1131 facilitates dust prevention and protection for the focusing lens 30. This eliminates the need for frequent cleaning of the focusing lens 30 and reduces contact between the focusing lens 30 and dust or processing debris. Thus, the focusing lens can maintain cleanliness over an extended period, thereby enhancing laser output power.

The focusing lens 30 is configured to be movable in the first chamber 1131 to adjust the focal position. In this way, by moving the focusing lens 30 to achieve different laser focal positions, the laser can process workpieces of different thicknesses, thus better meeting different processing requirements. The focusing lens 30 is moved for focusing. This structure is easy to implement and low in cost. Moreover, the structural design where the focusing lens 30 is located within the first chamber 1131 is more conducive to enhancing the movement stability and vibration resistance of the focusing lens 30. In this way, the accuracy of focusing by moving the focusing mirror 30 can be more easily guaranteed.

Optionally, with reference to FIG. 11 and FIG. 2, the laser module may further include a reflecting mirror 40. The reflecting mirror 40 is disposed between the laser emitting apparatus 80 and the focusing lens 30 and is configured to direct the laser emitted by the laser emitting apparatus 80 toward the focusing lens 30. It can be understood in conjunction with a laser path and a laser direction indicated by the dashed arrows in FIG. 6 and FIG. 2. The laser emitted by the laser emitting apparatus 80 can be refracted by the reflecting mirror 40 to the focusing lens 30, so that after passing through the focusing lens 30, the laser further exits through the laser exiting window lens 1122. The reflecting mirror 40 is also accommodated in the first chamber 1131, which facilitates dust prevention and protection of the reflecting mirror 40, eliminating the need for frequent cleaning of the reflecting mirror 40. Meanwhile, contact between the reflecting mirror 40 and dust or processing debris is reduced, which can maintain the cleanliness of the reflecting mirror over a long period, thereby enhancing the laser output power. Of course, in other embodiments, the reflecting mirror 40 may be omitted by arranging the laser emitting apparatus 80 and the focusing lens 30 to be directly opposite each other.

For example, the first housing 11 may generally be configured as a rectangular housing with a certain thickness, as shown in FIG. 3 and FIG. 1. More specifically, to facilitate the internal assembly of components such as the focusing lens 30, the first housing 11 is configured to include a focusing part housing 1102 and a focusing part cover plate 1101. The focusing part housing 1102 is provided with a laser entry opening 119 and a laser exit opening 1121. Of course, in other embodiments, the laser entry opening 119 and the laser exit opening 1121 may also be disposed on the focusing part cover plate 1101, or one of the laser entry opening 119 and the laser exit opening 1121 may be located on the focusing part housing 1102 and the other on the focusing part cover plate 1101.

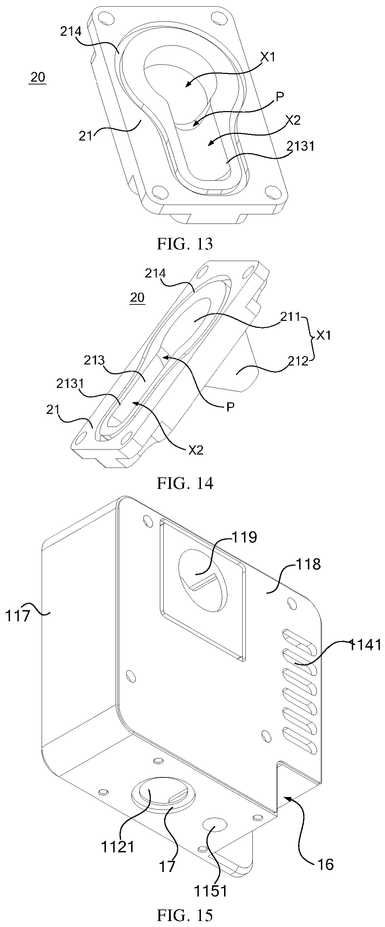

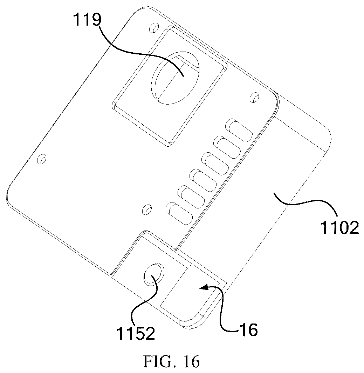

As shown in FIG. 15 and FIG. 16, the focusing part housing 1102 is a rectangular housing with a certain thickness, with one end in a thickness direction being an open port. The focusing part cover plate 1101 covers and shields the port of the focusing part housing 1102, and the first chamber 1131 is located in an area enclosed by the focusing part housing 1102 and the focusing part cover plate 1101.

To improve the heat dissipation of the first chamber 1131, a partition rib 1133 is disposed inside the focusing part housing 1102. The focusing part cover plate 1101 and the focusing part housing 1102 together define the first chamber 1131 on one side of the partition rib 1133, and the second chamber 1132 on the other side of the partition rib 1133. One or more second through-openings 1142 are provided on the focusing part cover plate 1101, and the second through-openings 1142 are in communication with the second chamber 1132. In this way, heat in the first chamber 1131 can be transferred to the second chamber 1132, and then passes through the second chamber 1132 to be dissipated to the external environment through the second through-openings 1142 by convection, achieving heat dissipation and cooling of the first chamber 1131. At the same time, direct communication between the first chamber 1131 and the external environment is unnecessary, which well balances the sealing performance of the first chamber 1131, thus ensuring its dust-proof effect of the first chamber 1131.

Optionally, the housing 10 further includes a second housing 12, and the laser module further includes a fan 50. The second housing 12 is connected to the first housing 11; the fan 50 is connected to the second housing 12 and is configured to generate a heat dissipation airflow to dissipate heat from the second housing 12. The second housing 12 has an air flow channel, and the fan 50 is in communication with the second chamber 1132 via the air flow channel. In this way, the fan 50 can drive airflow into the second chamber 1132 along the air flow channel, and after passing through the second chamber 1132, the airflow is discharged through the second through-openings 1142, thereby achieving forced convective heat exchange in the second chamber 1132 and improving the heat dissipation and cooling effect of the first chamber 1131.

Optionally, the direction of the heat dissipation airflow formed under the driving of the fan 50 is parallel to the direction of the air flow channel of the second housing 12. In this way, the fan 50 can drive more heat dissipation airflow into the second chamber 1132, and after passing through the second chamber 1132, the heat dissipation airflow is discharged through the second through-openings 1142, thereby improving the heat dissipation and cooling effect of the first chamber 1131.

To elaborate with more detailed examples, the shape of the fan 50 is generally similar to that of the first housing 11. The second housing 12 is generally configured as a rectangular body with a cross-sectional profile substantially the same as that of the first housing 11. The first housing 11 is located at one end of the second housing 12 in a length direction, and the fan 50 is located at the other end of the second housing 12 in the length direction. A rectangular main structure of the laser module is formed by assembling the second housing 12, the first housing 11, and the fan 50.

The focusing part housing 1102 specifically includes a bottom plate 118 disposed opposite the focusing part cover plate 1101, and a peripheral side wall 117 extending from the bottom plate 118 toward the focusing part cover plate 1101. The peripheral side wall 117 and the bottom plate 118 define a cavity. A partition rib 1133 is disposed inside the cavity. The partition rib 1133 protrudes from the bottom plate 118 and extends toward the focusing part cover plate 1101. The partition rib 1133 divides the cavity into two side chambers, one of which, together with the focusing part cover plate 1101, defines the first chamber 1131, and the other, together with the focusing part cover plate 1101, defines the second chamber 1132.

A through laser exit opening 1121 is formed in the peripheral side wall 117 located on a lower side of the first chamber 1131, and a through laser entry opening 119 is formed in the bottom plate 118 on the side of the first chamber 1131 close to the second housing 12. The laser entry opening 119 is configured to allow the emitting end 81 of the laser emitting apparatus 80 to extend into the first chamber 1131. Optionally, the laser entry opening 119 is located at an upper end of the bottom plate 118. In this way, there is a certain height difference in a vertical direction between the laser exit opening 1121 and the laser entry opening 119, which can provide sufficient space for the movement of the focusing lens 30, thereby facilitating a more compact spatial structure of the product.

The reflecting mirror 40 is located in the first chamber 1131 on the side of the emitting end 81 of the laser emitting apparatus 80 close to the focusing part cover plate 1101, and above the focusing lens 30. The reflecting mirror 40 is specifically configured to change a laser optical path horizontally entering the first housing 11 by 90 degrees, forming a laser emitted vertically downward, so that the laser can pass downward through the focusing lens 30 and the laser exit opening 1121 to the surface of the workpiece for processing or cleaning.

The area of the focusing part cover plate 1101 corresponding to the first chamber 1131 is configured as a closed structure, so as to help the first chamber 1131 maintain airtightness and prevent dust from entering the first chamber 1131. The focusing part cover plate 1101 is provided with second through-openings 1142 in the area corresponding to the second chamber 1132, and first through-openings 1141 are formed in the bottom plate 118 on the side of the second chamber 1132 close to the second housing 12. The second chamber 1132 is in communication with the second through-openings 1142 and the first through-openings 1141, respectively. In this way, under the driving of the fan 50, the heat dissipation airflow passes through the air flow channel of the second housing 12, enters the second chamber 1132 via the first through-openings 1141, and after passing through the second chamber 1132, is discharged via the second through-openings 1142.

Optionally, the first through-openings 1141 and the second through-openings 1142 are arranged opposite each other. In this way, under the driving of the fan 50, the intake and exhaust of the second chamber 1132 are more efficient, thereby achieving more efficient heat dissipation for the first chamber 1131.

A first accommodating space m1 and a second accommodating space m2 are provided inside the second housing 12. The first accommodating space m1 accommodates the laser emitting apparatus 80, and the second accommodating space m2 accommodates the circuit board 90. The fan 50 is arranged opposite both the first accommodating space m1 and the second accommodating space m2, so as to drive the heat dissipation airflow to flow through the first accommodating space m1 and the second accommodating space m2, respectively. In this way, the heat dissipation airflow dissipates heat from the laser emitting apparatus 80 and the circuit board 90, enabling the second housing 12 and the fan 50 to achieve a dual heat dissipation effect on the circuit board 90 as well as on the laser emitting apparatus 80.

Optionally, the first through-openings 1141 are in communication with at least one of the first accommodating space m1 and the second accommodating space m2. In this way, under the driving of the fan 50, the airflow passes through the first accommodating space m1 and/or the second accommodating space m2, then further passes through the first through-openings 1141, the second chamber 1132, and the second through-openings 1142, and is thereby discharged from the first housing 11, thus achieving heat dissipation for the first housing 11 and the components inside the first housing 11.

The second housing 12 includes a finned radiator. In this way, the heat of the laser emitting apparatus 80 and/or the circuit board 90 can be transferred to the second housing 12 and dissipated into the air through the fins of the second housing 12.

Optionally, the air flow channel of the second housing 12, which is configured to be in communication with the fan 50 and the second chamber 1132, may be gaps between the fins. And/or, optionally, the air flow channel of the second housing 12 for being in communication with the fan 50 and the second chamber 1132 may be the first accommodating space m1 and/or the second accommodating space m2.

Optionally, at least a portion of the fins of the second housing 12 are disposed externally, i.e., at least a portion of the fins of the second housing 12 are exposed on an outer surface of the laser module, which can further enhance the heat dissipation effect.

Optionally, at least a portion of the fins of the second housing 12 are located on a downstream side of the airflow from the fan 50. In this way, the dual heat dissipation functions of the fan 50 and the second housing 12 are realized. As the fan 50 drives the airflow through the second housing 12, the convective heat exchange between the fins of the second housing 12 and the air can be accelerated, thereby assisting in optimizing the heat dissipation efficiency of the laser emitting apparatus 80 and/or the circuit board 90 through the second housing 12.

In some embodiments, as shown in FIG. 12, the laser module further includes a ranging sensor 70. The ranging sensor 70 may specifically be, for example, an ultrasonic sensor, a laser sensor, etc. The ranging sensor 70 is disposed on the circuit board 90. A detection hole is formed in a surface of the second housing 12, and the ranging sensor 70 is exposed outside the second housing 12 via the detection hole. The ranging sensor 70 is configured to measure a thickness of the workpiece or a distance between the workpiece and the laser module.

Optionally, the detection hole is formed at the end of a bottom surface of the second housing 12 close to the first housing 11. Accordingly, the ranging sensor 70 is also located at the end of the bottom surface of the second housing 12 close to the first housing 11. In this way, when the workpiece is placed below the laser module, the ranging sensor 70 reads the thickness or distance of the workpiece, and the circuit board 90 of the laser module determines a target position of the focusing lens 30 based on the workpiece thickness or distance parameters from the ranging sensor 70, and controls the driving apparatus 60 to drive the focusing lens 30 to move to the determined target position.

Optionally, as shown in FIG. 12, a plurality of exhaust holes 1231 are also formed in the surface of the second housing 12. The plurality of exhaust holes 1231 are distributed around the detection hole and in communication with the second accommodating space m2. In this way, the gas discharged from the exhaust holes 1231 can provide a blocking effect around an area below the ranging sensor 70, similar to forming an annular gas wall surrounding a peripheral space below the ranging sensor 70, which can block dust from contacting the ranging sensor 70, thereby ensuring the reliability and accuracy of the ranging sensor 70. Of course, in other embodiments, a plurality of exhaust holes 1231 may be provided to be in communication with the first accommodating space m1, or a plurality of exhaust holes 1231 may be provided to be in communication with both the first accommodating space m1 and the second accommodating space m2.

Optionally, the driving apparatus 60 is electrically connected to the circuit board 90. The circuit board 90 controls the driving apparatus 60 to drive the focusing lens 30 to move to the determined position, which generally includes: the circuit board 90 determines the target position based on the workpiece thickness or distance parameters from the ranging sensor 70, and then issues a command corresponding to the target position; the motor 63 receives the command and drives the lead screw 64 to rotate according to the command. Through the cooperation of the lead screw 64 and the lead screw nut 66, the rotational output of the motor 63 is converted into linear motion of the lens holder 65, driving the focusing lens 30 to the target position corresponding to the command. Then the laser emitting apparatus 80 starts to emit a laser, and when the laser spot enters the reflecting mirror, the reflecting mirror changes the optical path by 90 degrees, converting the parallel laser into a vertically downward laser. The laser passes through the focusing lens 30, whose position has been adjusted by the motor 63, and then passes through the laser exiting window lens 1122 to reach the surface of the workpiece. At this time, the focal length is exactly on the surface of the workpiece, and laser processing begins.

Optionally, the driving apparatus 60 is also located in the first chamber 1131. This can further achieve the dust prevention and protection for the driving apparatus 60, and since the driving apparatus 60 and the focusing lens 30 are located within the same cavity, i.e., both are inside the first chamber 1131, the connection and assembly between the driving apparatus 60 and the focusing lens 30 are further simplified, and the number of sealing locations can be reduced, thereby better maintaining the dustproof effect of the first chamber 1131.

In some embodiments, as shown in FIG. 3 and FIG. 11, the laser module further includes an air nozzle 20. The air nozzle 20 is disposed on the first housing 11 and is used for allowing the laser to exit and for guiding the gas toward the workpiece to purge a laser processing position. The direction of the airflow can be roughly understood with reference to the dashed arrows in FIG. 11 and FIG. 6.

For example, the air nozzle 20 is connected to the first housing 11. To maintain the cleanliness of the surface of the laser exiting window lens 1122 and ensure the efficiency of laser emission and the accuracy of laser processing, specifically, as shown in FIG. 11, the air nozzle 20 is provided with a first channel X1 for exhaust and a second channel X2 for intake. The first channel X1 is arranged opposite the laser exit opening 1121 to enable the laser to sequentially pass through the laser exit opening 1121 and the first channel X1. One end of the second channel X2 converges at the end of the first channel X1 close to the laser exit opening 1121, and the first channel X1 is in communication with the second channel X2 at a convergence position P. In this way, when the gas in the second channel X2 is discharged into the first channel X1 at the convergence position of the second channel X2 and the first channel X1, the gas can purge across the surface of the laser exiting window lens 1122 at the laser exit opening 1121, thereby achieving automatic purging and cleaning of the laser exiting window lens. This structure achieves gas path planning through the design of an internal channel structure of the air nozzle 20, so that the gas used to purge the surface of the workpiece is also used to purge the laser exiting window lens 1122.

As shown in FIG. 11 and FIG. 6, the first channel X1 is configured as a gradually narrowing tapered port from the end close to the laser exit opening 1121 to the end away from the laser exit opening 1121. That is, the opening area of the end of the first channel X1 close to the laser exit opening 1121 is relatively large, while the opening area of the end of the first channel X1 away from the laser exit opening 1121 is relatively small. On one hand, this facilitates the acceleration of airflow at a gas outlet end of the air nozzle 20, and on the other hand, the airflow makes more sufficient contact with the surface of the laser exiting window lens 1122, thereby improving the purging cleanliness of the laser exiting window lens 1122.

Specifically, as an example, the whole first channel X1 or a portion of the first channel X1 may be configured as a conical shape as shown in FIG. 11, with a wider end of the cone close to the laser exit opening 1121 and a narrower end away from the laser exit opening 1121. The conical first channel X1 facilitates a smoother airflow transmission, thereby better ensuring a purging force on the laser processing position of the workpiece and enhancing the cleaning capability. Of course, the present design is not limited thereto. In other embodiments, the shape of the first channel X1 may also be replaced with a stepped transition shape or a flared shape with an arc-shaped side surface, etc.

The second channel X2 extends radially outward from the converging point with the first channel X1 along the first channel X1 for a certain distance. The second channel X2 is arranged orthogonally to the first channel X1, or the second channel X2 is arranged slightly inclined toward the direction of the laser exit opening 1121 relative to the first channel X1. The convergence position of the second channel X2 and the first channel X1 is located at the end of the first channel X1 axially close to the laser exit opening 1121. In this way, after entering the second channel X2, the gas first flows a certain distance along the second channel X2, so that the airflow can maintain a certain flow inertia as it passes through the convergence position of the first channel X1 and the second channel X2 and is injected radially into the first channel X1. Thus, the outer surface of the laser exiting window lens 1122 covering the laser exit opening 1121 is precisely purged by the radially flowing airflow, and the airflow provides better purging force and more uniform cleaning of the laser exiting window lens 1122.

With reference to FIG. 11 and FIG. 15, it can be understood that an air guide channel 115 is integrally formed in the first housing 11. The air guide channel 115 is in communication with the second channel X2, and the air guide channel 115 is not in communication with the first chamber 1131. Of course, in other embodiments, the air guide channel 115 and the first housing 11 may also be formed separately, and the air guide channel 115 is fixed and embedded as an insert embedded in a wall of the first housing 11. An air outlet 1151 in communication with the air guide channel 115 is also provided on the surface of the first housing 11 corresponding to the position of the air nozzle 20. The air outlet 1151 corresponds to the position of the second channel X2 and is in communication with the second channel X2. In this way, when the air nozzle 20 is assembled with the first housing 11, the air guide channel 115 is connected with and in communication with the second channel X2. This not only saves more assembly steps, but also makes it easier to maintain the stability of the connection and communication between the air guide channel 115 and the second channel X2.

Specifically, in some implementation scenarios, a direct connection pipeline component is generally used between the air nozzle 20 and an air pump. Compared with the structure in which the air nozzle 20 is directly connected to the air pump via a pipeline, the present structure adopts an air guide channel 115 integrally formed on the first housing 11 to be in communication with the air nozzle 20. This structure allows pipelines to be hidden or not exposed at the position of the air nozzle 20, thereby avoiding the problem of messy and unsightly exposed pipelines, and also avoiding the risks of pipeline compression, damage, or burning, thus improving the reliability of the product.

Optionally, the air outlet 1151 and the laser exit opening 1121 are located on the same side surface of the first housing 11 and are spaced apart from each other, which facilitates the integrated connection of the air nozzle 20 to both the laser exit opening 1121 and the air outlet 1151.

With reference to FIG. 11, FIG. 15, FIG. 16, and FIG. 6, it can be understood that a clearance recess 16 is recessed on the outer surface of the first housing 11, one end of the air guide channel 115 penetrates through to an inner surface of the clearance recess 16, so that an air inlet 1152 in communication with the air guide channel 115 is formed in the inner surface of the clearance recess 16. In this way, the end of the air guide channel 115 close to a gas source (such as an air pump) can be hidden and arranged in the clearance recess 16, and the connection position of the air inlet 1152 of the air guide channel 115 can utilize the clearance recess 16 for clearance protection and concealment, achieving better aesthetics and protection.

Optionally, the laser module further includes a connection nozzle 100. The connection nozzle 100 is accommodated in the clearance recess 16, and the connection nozzle 100 is inserted into the air inlet 1152. The clearance recess 16 can provide clearance protection and concealment for the connection nozzle 100. Thus, the connection nozzle 100 can be more conveniently connected to the gas source (such as an air pump for purging the workpiece) on the outside of the air guide channel 115.

Optionally, the laser module includes an air pump. An exhaust end of the air pump is connected to the connection nozzle 100, so that the air pump is in communication with the second channel X2 of the air nozzle 20 via the connection nozzle 100 and the air guide channel 115. The air pump may be an air pump used for purging the workpiece. Thus, the air pump with a dual purpose is used to purge the laser exiting window lens and further discharges gas along the first channel X1 for purging the workpiece, thereby simplifying the product components. Of course, in other embodiments, the laser module may not be provided with an air pump, but instead use an external air pump connected to the connection nozzle 100 to achieve purging of the laser exiting window lens 1122 and the workpiece.

In some embodiments, as shown in FIG. 11, the air nozzle 20 includes a connecting plate 21. The connecting plate 21 is covered and connected to a bottom surface of the first housing 11, and integrally covers the laser exit opening 1121 and the air outlet 1151. The connecting plate 21 is provided with a through hole 211 and a recess 213 having an opening 2131. The laser exit opening 1121 is aligned with the through hole 211. On the side of the connecting plate 21 facing away from the first housing 11, an annular tube 212 is arranged along an edge of the through hole 211 in a projecting manner. The annular tube 212 and the through hole 211 serve as the first channel X1, allowing the laser emitted by the laser emitting apparatus to pass through the through hole 211.

Optionally, the annular tube 212 is configured in a conical shape. The end of the annular tube 212 with a larger radial size is joined to the end of the through hole 211 away from the laser exit opening 1121, and the end of the annular tube 212 with a smaller radial size is far away from the through hole 211. In this way, the first channel X1 is partially configured as a gradually narrowing tapered opening.

The recess 213 serves as the second channel X2. The recess 213 intersects and is in communication with the through hole 211 and extends radially outward from the through hole 211. The recess 213 covers at least a portion of an outer wall of the first housing 11 and at least a portion of the laser exiting window lens 1122, so that the opening 2131 of the recess 213 is covered by at least a portion of the outer wall of the first housing 11 and at least a portion of the laser exiting window lens 1122. Thus, the recess 213, together with at least a portion of the outer wall of the first housing 11 and at least a portion of the laser exiting window lens 1122, defines a space for gas flow. The end of the opening 2131 away from the through hole 211 corresponds to and is in communication with the air outlet 1151, so that the air outlet 1151 is in communication with the space for gas flow. The air nozzle 20 of the present design satisfies the functions of light transmission, workpiece purging, and purging of the laser exiting window lens 1122. The structure is simplified to the greatest extent. The second channel X2 is designed with an opening 2131, which facilitates the integral molding and demolding of the air nozzle 20. Moreover, the second channel X2 and the convergence position of the second channel X2 and the first channel X1 are as close as possible to the laser exit opening 1121, thereby further enhancing the sufficiency of purging the laser exiting window lens 1122.

As shown in FIG. 11, a counterbore 17 is formed on the outer surface of the first housing 11. The counterbore 17 surrounds the laser exit opening 1121. The laser exiting window lens 1122 is accommodated in the counterbore 17. At least a portion of an edge of the laser exiting window lens 1122 is located between the connecting plate 21 and a bottom wall of the counterbore 17. In this way, the laser exiting window lens 1122 is further limited in position by the air nozzle 20, reducing the risk of the detachment of the laser exiting window lens 1122 and better ensuring the internal dustproof reliability of the first chamber 1131.

With reference to FIG. 11, FIG. 13, FIG. 14, and FIG. 2, it can be understood that an annular groove 214 for accommodating a sealing member is provided on the surface of the connecting plate 21 on the side close to the first housing 11. Both the opening 2131 and the through hole 211 are located within an area defined by the annular groove 214. A projection of the laser exiting window lens 1122 on the connecting plate 21 is located within the area defined by the annular groove 214. The provision of the annular groove 214 facilitates the positioning of the sealing member, achieving a more reliable sealing effect. The opening 2131 and the through hole 211 are both located within the area defined by the annular groove 214, and/or the projection of the laser exiting window lens 1122 on the connecting plate 21 is located within the area defined by the annular groove 214. In this way, the opening 2131, the through hole 211, and/or the laser exiting window lens 1122 are all located within the sealed area defined by the annular groove 214, resulting in better air tightness inside the air nozzle 20. Dust is also less likely to enter around the laser exiting window lens 1122.

Optionally, the laser exiting window lens 1122 is adhesively fixed to the first housing 11. In this way, the reliability of the connection between the laser exiting window lens 1122 and the first housing 11, as well as the dustproof effect, can both be improved. Of course, the present design is not limited thereto. In other embodiments, the laser exiting window lens 1122 and the first housing 11 may also be fixed to the first housing 11 by means of screws, buckles, or the limiting function of the air nozzle 20, etc.

The embodiments of the present application further provide a laser processing device, which includes a rail structure and the laser module as described in the above embodiments. The laser module is connected to the rail structure. The rail structure is configured to drive the laser module to move in a first direction and a second direction that are perpendicular to each other. The focusing apparatus of the laser module includes a driving apparatus 60 and a focusing lens 30 that are connected. The driving apparatus 60 drives the focusing lens 30 to move in a third direction. The third direction is perpendicular to the first direction and the second direction, i.e., the first direction, the second direction, and the third direction are perpendicular to each other in pairs. During processing of a workpiece, the workpiece is placed in the laser processing device and located below the emitting end 81 of the laser module. The driving apparatus 60 inside the laser module is controlled to operate and drive the focusing lens 30, thereby adjusting the focal position of the laser. After focusing is completed, the laser module emits a laser toward the workpiece for processing, while a rail apparatus drives the laser module to move in the first and second directions to change the relative position between the laser module and the workpiece, enabling the laser module to process a target pattern at different locations on the workpiece.

In summary, in the laser module and the laser processing device provided in the embodiments of the present application, the first chamber 1131 is configured inside the first housing 11, and the focusing apparatus is accommodated in the first chamber 1131, so that the focusing apparatus is not susceptible to dust contamination. In addition, in this design, the concealed air nozzle 20 is arranged on the outer surface of the laser exiting window lens 1122 at the laser exit opening 1121 and continuously blows air onto the surface of the laser exiting window lens 1122, ensuring the cleanliness of the outer surface of the laser exiting window lens 1122. The process of cleaning the lens is eliminated, making the product more convenient to use.

Although the present application has been described with reference to several exemplary embodiments, it should be understood that the terminology used is for illustrative and exemplary purposes only, rather than limiting. Since the present application may be embodied in various forms without departing from the spirit or essence of the present application, it should be understood that the above embodiments are not limited to any of the foregoing details, but should be interpreted broadly within the spirit and scope defined by the appended claims. Therefore, all variations and modifications falling within the scope of the claims or their equivalents should be covered by the appended claims.

## Claims

1. A laser module, comprising:
a housing, provided thereon with a laser exiting part capable of allowing a laser to be emitted from an interior of the housing;
a laser emitting apparatus, accommodated in the housing and configured to emit a laser; and
a focusing apparatus, accommodated in the housing and located between the laser exiting part and the laser emitting apparatus, wherein the focusing apparatus is configured to adjust a focal position of the laser emitting apparatus and allow the laser emitted by the laser emitting apparatus to be emitted from the laser exiting part.

2. The laser module according to claim 1, wherein the focusing apparatus comprises a driving apparatus and a focusing lens that are connected, the driving apparatus and the focusing lens are both accommodated in the housing, the focusing lens is configured to focus the laser emitted by the laser emitting apparatus, and the driving apparatus is configured to drive the focusing lens to move so as to adjust the focal position of the laser emitting apparatus.

3. The laser module according to claim 2, wherein
the focusing lens comprises a single-focal-length lens, and a moving distance of the single-focal-length lens is equal to a moving distance of a focal point of the laser emitting apparatus; or
the focusing lens comprises a multi-focal-length lens, and a ratio of the moving distance of the multi-focal-length lens to the moving distance of the focal point of the laser emitting apparatus is less than 1.

4. The laser module according to claim 2, wherein
the laser exiting part comprises a laser exiting window lens, the focusing lens is arranged parallel to the laser exiting window lens, and a moving direction of the focusing lens is arranged at an angle to a laser emitting direction of the laser emitting apparatus; and the laser module further comprises a reflecting mirror, the reflecting mirror is accommodated in the housing, and the reflecting mirror is arranged corresponding to the laser emitting apparatus and the focusing lens respectively, and is configured to reflect the laser from the laser emitting apparatus to the focusing lens.

5. The laser module according to claim 4, wherein the housing comprises:
a first housing, provided with the laser exiting part, wherein the reflecting mirror and the focusing lens are both accommodated in the first housing, and in the moving direction of the focusing lens, the focusing lens is located between the reflecting mirror and the laser exiting part; and
a second housing, an interior of which is in communication with an interior of the first housing, wherein the laser emitting apparatus is accommodated in the second housing, the laser emitting apparatus has an emitting end, and the emitting end is disposed opposite to the reflecting mirror and extends into the first housing to allow the laser emitted by the laser emitting apparatus to reach the reflecting mirror.

6. The laser module according to claim 5, wherein
a first chamber and a second chamber are formed in the first housing, and the first chamber and the second chamber are arranged adjacent to each other; the reflecting mirror and the focusing lens are both accommodated in the first chamber; the laser exiting part corresponds to the first chamber; one end of the second chamber is provided with a first through-opening; the first through-opening is in communication with the interior of the second housing; and the other end of the second chamber is provided with a second through-opening disposed opposite to the first through-opening.

7. The laser module according to claim 5, further comprising a fan,
wherein the second housing comprises a heat dissipation base and a heat dissipation cover, the heat dissipation base and the heat dissipation cover together define a first accommodating space, the laser emitting apparatus is accommodated in the first accommodating space, the fan is disposed at the end of the heat dissipation base and/or the heat dissipation cover away from the first housing, and the fan is configured to generate an airflow to reduce the heat of the heat dissipation base and/or the heat dissipation cover.

8. The laser module according to claim 2, wherein the driving apparatus comprises:
a bracket, connected to the housing, wherein both ends of the bracket are respectively provided with end plates arranged at an angle to the bracket, and the two end plates correspond to each other and are spaced apart from each other;
a lead screw nut, provided with a lens holder for fixing the focusing lens;
a lead screw, extending between the two end plates, wherein the lead screw is threadedly connected to the lead screw nut, and the lead screw is rotated to drive the lead screw nut to move in an axial direction of the lead screw; and
a motor, provided on one of the end plates, wherein the lead screw passes through the end plate and is in transmission connection with the motor, and the motor is configured to drive the lead screw to rotate.

9. The laser module according to claim 8, wherein the driving apparatus further comprises:
guide rods, wherein both ends of each of the guide rods are respectively connected to the two end plates; two guide rods are disposed, and the lead screw is located between the two guide rods in a direction perpendicular to a moving direction of the lead screw nut; and
a middle portion of the lead screw nut is sleeved on the lead screw, and both side ends of the lead screw nut are each provided with an open slot, and the two guide rods are respectively inserted into the open slots at both side ends of the lead screw nut.

10. The laser module according to claim 1, further comprising:
a ranging sensor, disposed on the housing and configured to detect thickness information of an object to be processed, so that the focusing apparatus adjusts the focal position of the laser emitting apparatus based on the thickness information.

11. The laser module according to claim 10, wherein
the ranging sensor comprises an ultrasonic sensor; and
the ranging sensor and the laser exiting part are located on the same side of the housing and are spaced apart.

12. The laser module according to claim 1, wherein
the housing is provided with an air guide channel, and a surface of the housing is provided with an air outlet in communication with the air guide channel; and
the laser module further comprises an air nozzle, the air nozzle is connected to the housing and covers the air outlet and the laser exiting part, a first channel facing the laser exiting part is formed inside the air nozzle, and a second channel is further defined inside the air nozzle and is in communication with the air outlet and the first channel.

13. A laser processing device, comprising a rail structure and the laser module according to any one of claims 1 to 12, wherein the laser module is connected to the rail structure, and the rail structure is configured to drive the laser module to move in a first direction and a second direction that are perpendicular to each other; and
the focusing apparatus of the laser module comprises a driving apparatus and a focusing lens that are connected; and the driving apparatus drives the focusing lens to move in a third direction, and the third direction is perpendicular to the first direction and the second direction.
